# EUROPÄISCHE PATENTSCHRIFT

(11) **EP 0 908 079 B1**
(45) Veröffentlichungstag und Bekanntmachung des Hinweises auf die Patenterteilung: **19.04.2000**
(21) Anmeldenummer: 97904989.7
(22) Anmeldetag: 09.01.1997
(51) Int. Cl.: H05K 7/20

(54) **VERBINDUNGSELEMENT**
CONNECTOR
ELEMENT DE CONNEXION

(30) Priorität: 27.06.1996 DE 19625755
(43) Veröffentlichungstag der Anmeldung: 14.04.1999
(73) Patentinhaber: ROBERT BOSCH GMBH, 70442 Stuttgart (DE)
(72) Erfinder: JOCHAM, Reinhold, D-72379 Hechingen (DE); SCHONDELMAIER, Harald, D-72827 Wannweil (DE)
(86) Internationale Anmeldenummer: DE9700026
(87) Internationale Veröffentlichungsnummer: WO9801014

(56) Entgegenhaltungen:
- EP-A- 0 234 021
- DE-A- 2 443 988
- DE-A- 3 338 165
- DE-A- 3 818 428
- US-A- 4 521 170

## Beschreibung

### Stand der Technik

Die Erfindung betrifft ein Verbindungselement für eine mechanische und thermische Kopplung von Baugruppen nach dem Oberbegriff des Hauptanspruchs.

Es sind bereits aus der DE-OS 42 22 838 Verbindungselemente für Baugruppen eines elektrischen Geräts bekannt, bei denen Leistungsbauelemente die Verlustwärme erzeugen auf der eine Steuergeräteelektronik tragenden Leiterplatte angeordnet sind. Um die Verlustwärme der Leistungsbauelemente dieser Baugruppe abzuleiten hat eine wärmeleitende Schicht auf der Leiterplatte auch Kontakt zu Teilen des Gehäuses, so daß als Kühlelement auch das Gehäuse in Frage kommen kann. Es ist hier jedoch nur eine Kontaktierung einer separaten Leiterplatte mit einem Gehäuse beschrieben ohne die mechanischen und thermischen Probleme bei der Kontaktierung größerer Baugruppen zu berücksichtigen.

### Vorteile der Erfindung

Das erfindungsgemäße Verbindungselement für eine mechanische und thermische Kopplung von Baugruppen ist mit den kennzeichnenden Merkmalen des Anspruchs 1 insbesondere dadurch vorteilhaft, daß eine gute thermische Kopplung bei einer flexiblen Verbindungs- und Trennungsmöglichkeit der Baugruppen gewährleistet ist. Durch den federnden Anschlag der Hülse an einen Ansatz eines Stiftes können Fertigungstoleranzen der Baugruppen ausgeglichen werden ohne den thermischen Kontakt zu beeinträchtigen. Auch im Falle verschiedener Erwärmungen oder unterschiedlicher Wärmeausdehnungskoeffizienten der Baugruppen bleibt ein guter mechanischer und thermischer Kontakt erhalten, da mit einem federnden Ring ein Ausgleich dieser Toleranzen möglich ist.

Vorteilhafte Ausführungsformen sind in den Unteransprüchen angegeben.

### Zeichnung

Ein bevorzugtes Ausführungsbeispiel des erfindungsgemäßen Verbindungselements wird anhand der Zeichnung erläutert. Es zeigen:
Figur 1 im oberen Teil eine Draufsicht und im unteren Teil eine Schnittdarstellung durch einen Stift und eine Hülse mit federndem Ring als Verbindungselement und
Figur 2 eine detaillierte perspektivische Prinzipskizze des Verbindungselements.

### Beschreibung des Ausführungsbeispiels

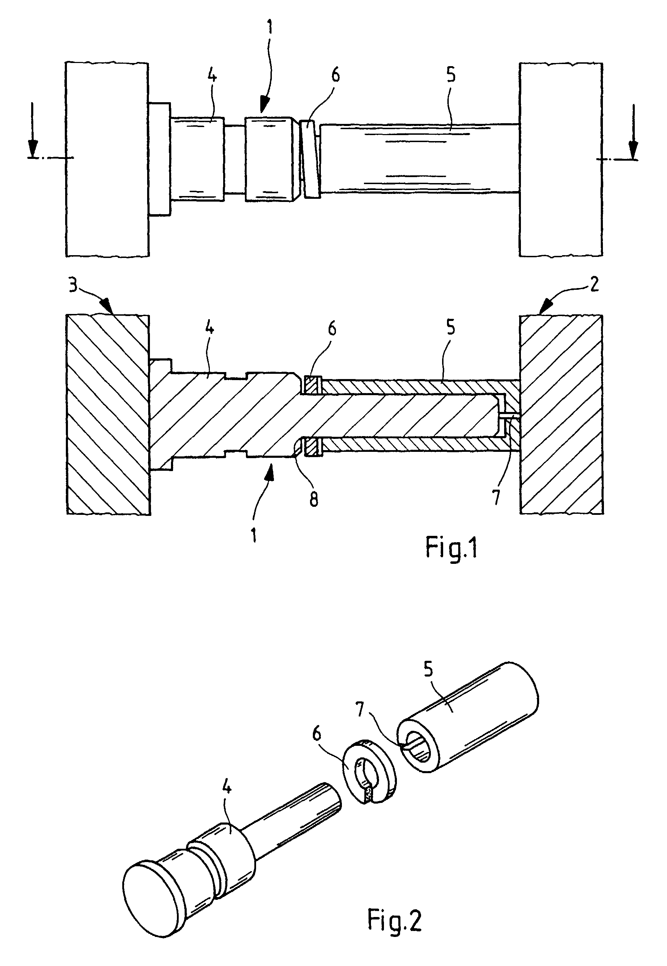

In Figur 1 sind Verbindungselemente 1 gezeigt, die zwischen zwei Baugruppen 2 und 3 angeordnet sind und eine mechanische und thermische Verbindung zwischen diesen Baugruppen 2 und 3 herstellen sollen. An der Baugruppe 3 ist ein Stift 4 gehalten, entweder durch Verklebung oder durch den mechanischen Anpreßdruck, und an der Baugruppe 2 ist eine axial geschlitzte Hülse 5 in gleicher Weise wie der Stift 4 befestigt.

Aus der Schnittdarstellung im unteren Teil der Figur 1 ist die Lage dieser Teile und insbesondere auch die eines federnden Rings 6 an einem Ansatz 8 des Stiftes 4 zu erkennen. Die Figur 2 zeigt eine perspektivische Darstellung der Teile 4, 5 und 6, wobei auch ein axialer Schlitz 7 in der Hülse 5 gezeigt ist.

Die oben beschriebenen Figuren lassen deutlich erkennen, wie nach einem Aufstecken der Hülse 5 auf den Stift 4 eine guter mechanischer und thermischer Kontakt zwischen den Baugruppen 2 und 3 herstellbar ist und dabei über den federnden Ring 6 unterschiedliche Wärmeausdehnungen und Fertigungstoleranzen der Baugruppen 2 und 3 ausgleichbar sind.

## Patentansprüche

1. Verbindungselement für eine mechanische und thermische Kopplung von Baugruppen (2,3), **dadurch gekennzeichnet, daß**
- an einer der Baugruppen(3)ein wärmeleitender Stift (4) und an der anderen, der Verbindungsstelle gegenüberliegenden, Baugruppe (2) eine wärmeleitende Hülse (5) angeordnet ist, wobei die-Hülse (5) auf den Stift (4) mit einer Preßpassung aufsteckbar ist und daß
- die Hülse (5) nach dem Aufstecken über einen federnden Ring (6) an einem Ansatz (8)des Stiftes (4) anliegt.

2. Verbindungselement nach Anspruch 1, **dadurch gekennzeichnet, daß**
- der Stift (4) und/oder die Hülse (5) mit der Oberfläche der jeweiligen Baugruppe (2,3) verklebt sind.

3. Verbindungselement nach Anspruch 1 oder 2, **dadurch gekennzeichnet, daß**
- der Stift (4) und die Hülse (5) aus Metall hergestellt sind.

4. Verbindungselement nach einem der Ansprüche 1 bis 3, **dadurch gekennzeichnet, daß**
- die Hülse (5) zumindest teilweise einen axialen Schlitz (7) aufweist.

## Claims

1. Connecting element for a mechanical and thermal coupling of subassemblies (2, 3), characterized in that
- a heat-conducting pin (4) is arranged on one of the subassemblies (3) and a heat-conducting sleeve (5) is arranged on the other subassembly (2) which lies opposite the joint, it being possible for the sleeve (5) to be plugged onto the pin (4) with a press fit, and in that
- after being plugged on, the sleeve (5) bears, via a resilient ring (6), against a shoulder (8) of the pin (4).

2. Connecting element according to Claim 1,
characterized in that
- the pin (4) and/or the sleeve (5) is/are bonded to the surface of the particular subassembly (2, 3).

3. Connecting element according to Claim 1 or 2,
characterized in that
- the pin (4) and the sleeve (5) are produced from metal.

4. Connecting element according to one of Claims 1 to 3, characterized in that the sleeve (5) has an axial slot (7) over at least part of it.

## Revendications

1. Elément de liaison pour l'accouplement thermique et mécanique de sous-ensembles (2, 3),
caractérisé en ce qu'
• on dispose sur l'un des sous-ensembles (3) une broche qui conduit la chaleur (4) et sur l'autre sous-ensemble (2), qui se trouve en regard du point de liaison, un manchon (5) conduisant la chaleur, le manchon (5) pouvant être enfiché sur la broche (4) avec un ajustement serré et
• le manchon (5) repose, après avoir été enfilé, sur un appendice (8) de la broche (4), au moyen d'une bague (6), qui fait ressort.

2. Elément de liaison selon la revendication 1,
caractérisé en ce que
la broche (4) et/ou le manchon (5) sont collés avec la surface du sous-ensemble correspondant (2, 3).

3. Elément de liaison selon la revendication 1 ou 2,
caractérisé en ce que
la broche (4) et le manchon (5) sont réalisés en métal.

4. Elément de liaison selon l'une des revendications 1 à 3,
caractérisé en ce que
le manchon (5) présente au moins en partie une fente axiale (7).
